# EUROPEAN PATENT APPLICATION

(11) **EP 1 628 351 A1**
(43) Date of publication of application: **22.02.2006**
(21) Application number: 04732788.7
(22) Date of filing: 13.05.2004
(51) Int. Cl.: H01L 41/187, H01L 41/24

(54) **PIEZOELECTRIC MATERIAL, MANUFACTURING METHOD THEREOF, AND NON-LINEAR PIEZOELECTRIC ELEMENT**

(30) Priority: 13.05.2003 JP 2003134630; 30.03.2004 JP 2004101468
(71) Applicant: Japan Science and Technology Agency, Kawaguchi-shi, Saitama 332-0012 (JP); National Institute for Materials Science, Tsukuba-shi, Ibaraki 305-0047 (JP)
(72) Inventor: REN, Xiaobing, Tsukuba-shi, Ibaraki 305-0031 (JP)
(74) Representative: Calamita, Roberto
(86) International application number: PCT/JP2004/006761
(87) International publication number: WO 2004/102689

(57) **Abstract**

A piezoelectric material is provided that has mobile point defects which are arranged so that the short-range order symmetry is matched with the crystal symmetry of the ferroelectric phase. A large non-linear electrostrain effect is obtained by the reversible domain switching under electric field in the ferroelectric material. Thus, it is possible to provide a piezoelectric material and its element having a large and steep deformation even at low voltage. Its manufacturing method is also disclosed.

## Description

### Technical Field

The invention of this application relates to a piezoelectric material and a piezoelectric element, and particularly, to a material of a non-linear piezoelectric characteristic which can be largely deformed at low voltage and an element using the material.

### Background Art

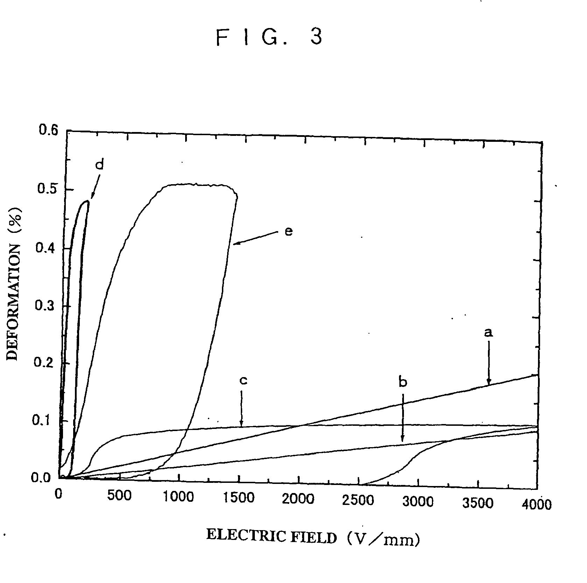

As methods of obtaining deformation by an electric field, the following two methods are known.
(1) A ferroelectric phase of a ferroelectric material is subjected to a "poling" process to obtain an approximately linear piezoelectric effect (deformation by electric field). As a characteristic feature of this method, domains of the ferroelectric material fixed by the poling process (i.e., the domains are not rotated), positive and negative ions in a crystal are moved by application of the electric field to obtain the linear piezoelectric deformation. Pb(ZrTi)O₃ (PZT) serving as a typical piezoelectric material obtains piezoelectric effect by using the method. This is a so-called poled PZT ceramics [soft type (see curve a in the accompanying drawing in FIG. 3) and hard type (see curve b in FIG. 3)].
(2) Non-linear piezoelectric effect is obtained by using electric field induced phase transition of an antiferroelectric material. As a characteristic feature of this method, a strong electric field is applied to an antiferroelectric material so as to change its state into a ferroelectric state, thereby obtaining non-linear deformation [A typical example of this type is shown as curve c in FIG. 3, which shows the non-linear electrostrain during an electric field induced antiferroelectric material - dielectric material phase transition in PNZST ceramics].

As any one of the above methods, with respect to a piezoelectric material which achieves a deformation by electric field and a piezoelectric element using the piezoelectric material, in recent years, with rapidly expanding application to sensors such as acceleration sensor, knocking sensor, or AE sensor, ultrasonic microphone, piezoelectric loudspeaker, piezoelectric actuator, ultrasonic motor, printer head, gun for ink-jet printer, and the like, a high conversion efficiency is required in application to the actuator or the sensor. In particular, with respect to the actuator which converts a voltage into deformation, the actuator which can produce a large stroke (deformation) at low voltage is required. In addition, the deformation is desired to be non-linear (for example, a deformation sharply increases at a critical voltage). However, in the conventional technique described above, the following problems have been posed.

For example, in the conventional technique described in item (1) (see curves a and b in FIG. 3), <1> a deformation is small at low voltage (only a deformation of 0.01 % to 0.1% occurs at an electric field of 1000 V/mm). <2> A deformation is almost linear with electric field. <3> A poling process is required in an electrode direction.

In the conventional technique described in item (2) (see the curve c in FIG. 3), <1> a drive electric field is large (> 2500 V/mm). <2> The maximum deformation is small (0.01 % to 0.08 %). <3> The characteristic has the disadvantage of being very sensitive to temperature.

The inventor of this application made a fundamental reexamination to the conventional piezoelectric materials. In this case, the following points are noted. That is, the inverse piezoelectric or electrostrain effect in the conventional material is due to the tiny shifts of ions, which causes slight change in crystalline lattice. Therefore, the resulting strain is extremely small. On the other hand, it is noticed that regions having different electric polarization directions (called domains) exist in the piezoelectric material. The polarization directions of domains may have angles of 180°, 90°, and the like depending on crystal symmetry. When an electric field is applied, domain switching occurs such that a polarization direction is changed to the field direction. For example, an a-domain having polarization perpendicular to the electric field is converted into a c-domain such that polarization direction is along the electric field direction when the electric field is applied. With this domain switching, the long-axis direction and the short-axis direction of the low symmetry ferroelectric phase are exchanged. The magnitude of the electrostrain obtained in this process is the length difference between the long and short axis. The magnitude can in principle reach as large as 1 % to 5 % depending on material. The value is tens of times as large as that obtained in a conventional piezoelectric effect. However, this giant electrostrain effect is generally irreversible, thus it is of little use.

However, the inventor noticed a way that can make the domain switching reversible, so that it makes possible to obtain a giant recoverable electrostrain effect.

On the basis of new principle, the inventor hereby provides a new way to develop non-linear piezoelectric material which can achieve a large and sharp deformation at low voltage and non-linear piezoelectric element, electric device or machine as an application of the non-linear piezoelectric element.

### Disclosure of Invention

The application provides the following inventions to solve the above problems.
[1] A piezoelectric material which is a ferroelectric having mobile point defects, wherein the mobile point defects are arranged such that the symmetry of short-range order of the point defects coincides with the crystal symmetry of the ferroelectric phase. Such piezoelectric material exhibits a characteristic non-linear piezoelectric effect caused by reversible switching of domains under electric field.
[2] The piezoelectric material is characterized by the existence of vacancies as the mobile point defects in a ferroelectric material. Such defects are either introduced by chemical equilibrium or addition of dopant(s).
[3] The piezoelectric material described in any one of the above items is subject to an aging treatment at a temperature below Curie temperature, and the point defecst are arranged such that the symmetry of the short-range order of the point defects coincides with the crystal symmetry of the ferroelectric phase.
[4] The piezoelectric material described in any one of the above items, wherein the piezoelectric material is a single crystal or a polycrystal.
[5] The piezoelectric material described in any one of the above items, wherein the piezoelectric material is a thin film.
[6] The piezoelectric material described in any one of the above items, wherein the piezoelectric material is a multilayer film.
[7] The piezoelectric material described in any one of the above items, wherein the ferroelectric material is ABO₃-type ferroelectric material.
[8] The piezoelectric material described in any one of the above items, wherein the ferroelectric material is BaTiO₃, (Ba, Sr)TiO₃-type ferroelectric material.
[9] The piezoelectric material described in any one of the above items, wherein the ferroelectric material is Pb(Zr, Ti)O₃ or (Pb, rare-earth element)(Zr, Ti)O₃-type ferroelectric material.
[10] The piezoelectric material described in any one of the above items, wherein other element is added.
[11] The piezoelectric material described in any one of the above items, wherein the other element is at least one element of an alkali metal, an alkali-earth metal, and a transition metal.
[12] The piezoelectric material described in any one of the above items, wherein the other element is added by 20 mol % or less.
[13] The piezoelectric material described in any one of the above, wherein the other element is at least one of Na, K, Mg, Ca, Al, V, Cr, Mn, Fe, Co, Ni, Zn, Ga, Rb, Sr, Y, Zr, Nb, Mo, Ru, Rh, Ag, Sn, Hf, Ta, W, Os, Ir, Pt, Pb, Bi, and a rare-earth element.
[14] A piezoelectric material exhibiting a non-linear piezoelectric effect, wherein the piezoelectric material is at least one of ABO₃-type ferroelectric material and a ferroelectric material obtained by adding other element to ABO₃-type ferroelectric material, and wherein the piezoelectric material has been subjected to an aging treatment at a temperature below Curie temperature.
[15] The piezoelectric material exhibiting the non-linear piezoelectric effect, wherein the piezoelectric material is at least one of BaTiO₃, (Ba, Sr)TiO₃, and a ferroelectric material obtained by adding at least one of K, Fe, and Mn to BaTiO₃ or (Ba, Sr)TiO₃.
[16] The piezoelectric material exhibiting the non-linear piezoelectric effect, wherein the piezoelectric material is (Pb, La)(Zr, Ti)O₃ ferroelectric material.
[17] A method of manufacturing a piezoelectric material described in any one of the above items, including steps of: introducing mobile point defects in a ferroelectric material; and arranging the point defects such that the symmetry of short-range order of the mobile point defects coincides with the crystal symmetry of the ferroelectric phase, and wherein the ferroelectric material exhibits a non-linear piezoelectric effect by reversible switching of domains thereof under electric field.
[18] A method of manufacturing a piezoelectric material exhibiting a non-linear piezoelectric effect, wherein at least one of ABO₃-type ferroelectric material and a ferroelectric material obtained by adding other element to ABO₃-type ferroelectric material is subjected to an aging treatment at a temperature below Curie temperature.
[19] The method of manufacturing a piezoelectric material, wherein the piezoelectric material is at least one of BaTiO₃, (Ba, Sr)TiO₃, and a ferroelectric material obtained by adding at least one of K, Fe, and Mn to BaTiO₃ or (Ba, Sr)TiO₃.
[20] The method of manufacturing a piezoelectric material, wherein the piezoelectric material is (Pb, La)(Zr, Ti)O₃ ferroelectric material.
[21] A non-linear piezoelectric element wherein one or more of the piezoelectric materials constitutes the non-linear piezoelectric element.
[22] An electric device or machine or parts thereof, wherein a non-linear piezoelectric element is incorporated as at least a part of a configuration.
[23] An electric device or machine or parts thereof, wherein any one of the piezoelectric materials is used as at least a part of the configuration of the electric device or machine or parts thereof.

As described above, the invention of this application is derived by utilizing his fundamental finding about the symmetry-conforming nano-ordering of point defects (Xiaobing Ren and Kazuhiro Otuka PHYSICAL REVIEW LETTERS Vol. 85, No. 5, 2000 July 31, pp. 1016 to 1019), which makes domain switching reversible, thereby a giant electrostrain effect can be obtained. More specifically, the invention of this application is accomplished as a novel technical idea based on a novel technical knowledge.

### Brief Description of Drawings

FIG. 1 is a schematic two-dimensional diagram showing the principle of the symmetry-conforming property of point defects in the crystal structure of a piezoelectric material according to the invention of this application.
FIG. 2 is a schematic diagram for explaining formation of a piezoelectric material which exhibits a giant non-linear piezoelectric effect of the invention of this application.
   Reference numerals and symbols in FIGs. 1 and 2 denote the followings:
   B point defect (site 0)
   1 to 4 sites neighboring point defect B (at site 0)
   P probability of finding another defect near site 0 (occupied by point defect B) in equilibrium
   11,14 symmetry of short-range order of point defects
   12, 13 crystal symmetry
   21 ferroelectric material in paraelectric state (above Curie temperature)
   22 ferroelectric material including a domain in which symmetry of short-range order of point defects does not coincide with crystal symmetry
   22A, 22B, 23A, 23B twin-related domains
   23 ferroelectric material including a domain in which symmetry of short-range order of point defects coincides with crystal symmetry
   24 the state obtained when an electric field is applied to the ferroelectric material in state 23
FIG. 3 is a figure (compared with conventional technique) showing an electric field - deformation characteristic of the piezoelectric material of the invention of this application.

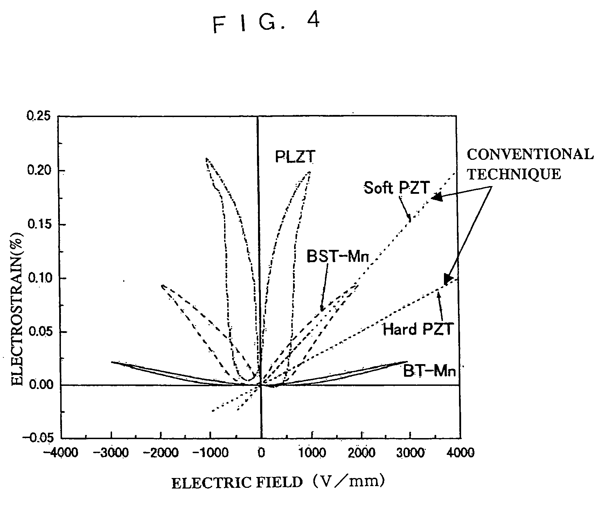

FIG. 4 is a graph showing another electric field - deformation characteristic of the invention of this application.

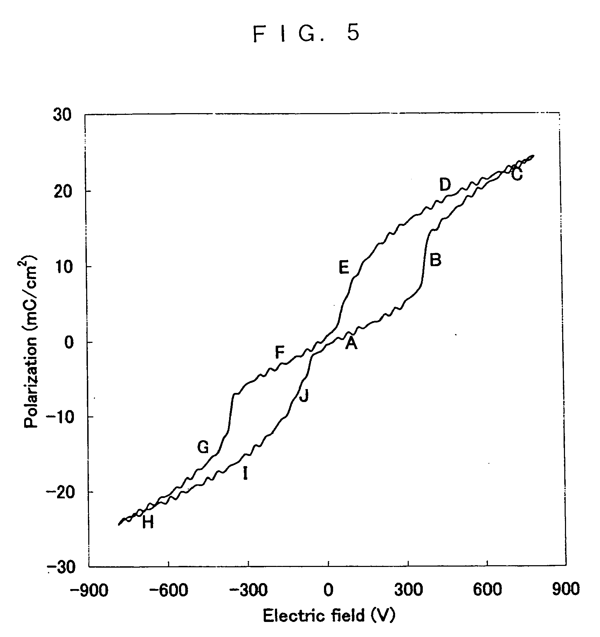

FIG. 5 is a graph showing a voltage - polarization characteristic obtained by reversible domain switching in a voltage cycle with respect to the piezoelectric material of the invention of this application.

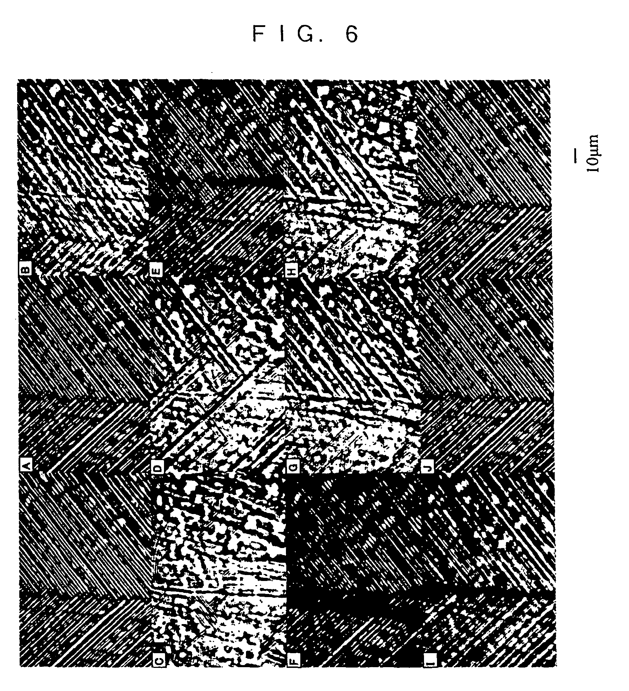

FIG. 6 is an optical microscopy photograph showing reversible switching of domains of the piezoelectric material in accordance with FIG. 5.

### Best Mode for Carrying Out the Invention

The invention of this application has the characteristic features described above. The invention of this application will be described below in detail.

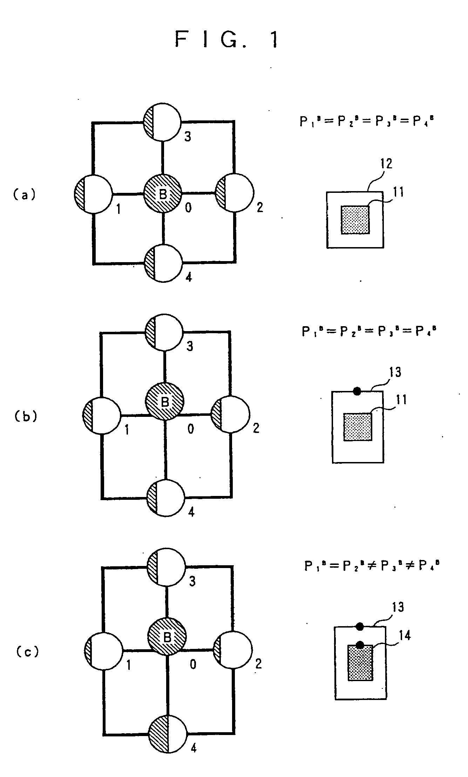

FIG. 1 is a schematic two-dimensional diagram showing the principle of symmetry-conforming property of point defects in the crystal structure of a piezoelectric material of the invention of this application.

The following description will be given with reference to FIG. 1.
(1) In the invention of this application, a ferroelectric material has mobile points defects. The "ferroelectric material" mentioned here is defined as a "material having spontaneous polarization which can be switched by an external electric field". A "point defect" means, in the invention of this application, a defective lattice site, a vacancy, or a dopant (ion) in a crystal.
   As methods of introducing point defects in a ferroelectric material, two typical methods are considered, for example.
   <1> Point defects (oxygen vacancies or the like) are naturally generated by chemical equilibrium during the processing procedure (crystal growth, high-temperature sintering, heat treatment, and the like) for manufacturing an element.
   <2> Point defects are introduced by doping (ion). For example, ions having different valences are doped in A-site or B-site of ABO₃-type ferroelectric material to introduce point defects such as oxygen vacancy, A vacancy, and B vacancy.

   With the introduction of the point defects, when the probability of finding another defect occupying region around a certain point defect (nanometer region) is considered, as having been reported by the inventor, the occupation probability shows a symmetry that coincides with symmetry of the crystal in equilibrium. This is called symmetry-conforming principle of a nano-ordering of point defects.
   According to the symmetry principle, in a paraelectric state (above Curie temperature) of a ferroelectric material in FIG. 1(a), reference symbol B denotes a point defect (at site 0), reference numerals 1 to 4 denote sites neighboring the point defect B (at site 0), and reference symbol P (shaded regions in FIG. 1(a)) denotes a probability of finding other defects in the sites 1 to 4 neighboring the site 0 (occupied by point defect B) in equilibrium. In such a case, the probabilities P at these sites are given by P₁^{B} = P₂^{B} = P₃^{B} = P₄^{B}, i.e., are equal to each other. More specifically, a stable state in which symmetry 11 of short-range order of the point defects coincides with crystal symmetry 12 is established.
   Therefore, point defect symmetry is high in a paraelectric phase. Similarly, the symmetry (in equilibrium) of point defects in a ferroelectric phase follows crystal symmetry, and at the same time, point defect polarization caused by the point defects coincides with the spontaneous polarization.
   When the material is cooled (without diffusion), ferroelectric transformation to a state shown in FIG. 1(b) occurs. At this time, the probabilities P at the sites 1 to 4 are kept at P₁^{B} = P₂^{B} = P₃^{R} = P₄^{B}. However, in this case, the symmetry 11 of the short-range order of point defects does not coincide with crystal symmetry 13 is established, thus it is an unstable state.
   Therefore, upon cooling paraelectric phase of the piezoelectric material changes into a ferroelectric phase with low crystal symmetry. At this time, the symmetry of the point defects in ferroelectric state inherits that in the paraelectric phase, and thus it is an unstable state.
(2) Therefore, in a piezoelectric material of the invention of this application, as shown in FIG.1(c), the probabilities in the sites 1 to 4 are given by P₁^{B} = P₂^{B}≠ P₃^{B}≠ P₄^{B}, so that symmetry 14 of short-range order of point defects is changed to follow the crystal symmetry 13. This state is the most stable state. The coincidence of the symmetries is made possible by an aging treatment for example. The aging treatment should be done at a temperature below Curie temperature. The aging time is dependent on an aging temperature. In general, the aging time is desirably one day or longer. When the aging treatment is performed at a predetermined temperature, the state is gradually saturated, and there is little further change with prolonged aging.

The coincidence between the symmetries, i.e., the symmetry of the short-range order of the mobile point defects is made to coincide with the symmetry of the crystal in the ferroelectric phase. This provides a piezoelectric material with a non-linear electrostrain effect obtained by reversible domain switching under electric field in the invention of this application.

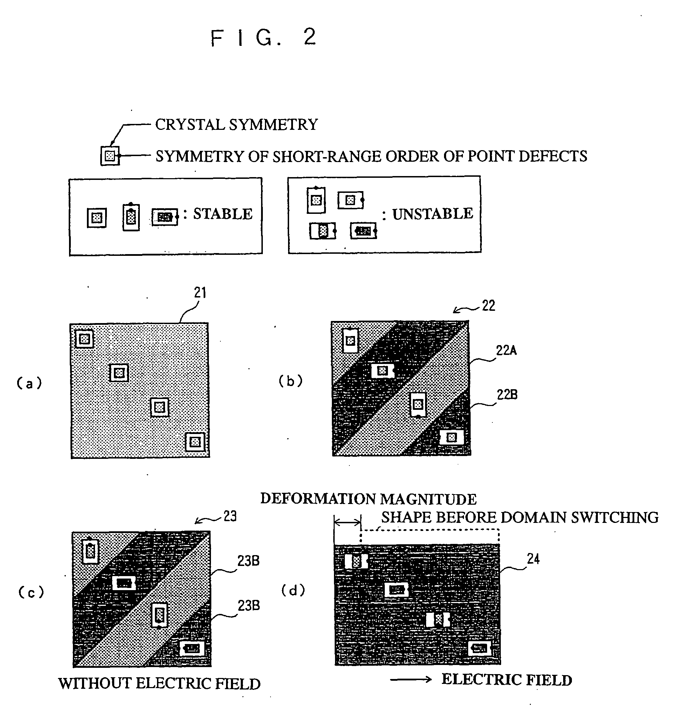

Next, realization of giant electrostrain under the electric field by reversible domain switching will be described below by FIG. 2. FIG. 2 also explains a method of manufacturing a piezoelectric material of the invention of this application.
(1) A ferroelectric material 21 in a paraelectric state in FIG. 2(a) is prepared. The material 21 has a stable state in which the symmetry 11 of the short-range order of the point defects coincides with the crystal symmetry 12, as shown in FIG. 1(a).
(2) The ferroelectric material 21 in FIG. 2(a) is cooled to obtain a ferroelectric material 22 including domains in FIG. 2(b) by the transformation of the ferroelectric material. The ferroelectric material 22 is set in an unstable state in which the symmetry 11 of the short-range order of the point defects does not coincide with the crystal symmetry 13, as shown in FIG. 1(b).
(3) The ferroelectric material 22 in FIG. 2(b) is subjected to an aging treatment to obtain a ferroelectric material 23 shown in FIG. 2(c), which includes domains in which symmetry 14 of short-range order of point defects is made to coincide with the crystal symmetry 13, as shown in FIG. 1(c), The ferroelectric material 23 is now set in the most stable state, and corresponds to a piezoelectric material of the invention of this application.
(4) Therefore, as shown in FIG. 2(d), when an electric field is applied to the domain of the ferroelectric material 23 including the domain as shown in FIG. 2(c) and then removed, the domain of the ferroelectric phase subjected to the aging treatment is reversibly switched according to the application and removal of the electric field. More importantly, a larger piezoelectric deformation: electrostrain is generated by the switching. Reference numeral 24 in FIG. 2(d) shows a state obtained when the electric field is applied to the ferroelectric material 23 shown in FIG. 2(c) [in FIG. 2(d), the shape indicated by the dotted line shows the shape before the electric field shown in FIG. 2(c) is applied].

In order to obtain a larger deformation, it is preferably to use ferroelectric materials containing non-180° domains. The low-symmetry ferroelectric materials shown in FIGs. 2(b) and 2(c) contain a large number of non-180° twin-related domains 22A and 22B : 23A and 23B.

With respect to the piezoelectric material of the invention of this application which exhibits the piezoelectric deformation as described above, the crystal structure may be single crystalline or polycrystalline. The shape of the crystal may be a bulk or a thin film. The shape may also be a multilayered film. The various crystal structures and shapes may be formed by conventionally known techniques. For example, various means of liquid-phase methods or vapor-phase methods may be employed to make thin films or multilayered films.

A ferroelectric material constituting a piezoelectric material of the invention of this application is not limited in composition. However, a conventionally known ABO₃-type composite oxide or a material obtained by adding another element (ion) to the oxide is preferably considered. As typical examples of ABO₃-type composite oxide, not only BaTiO₃-type material and (Ba, Sr) TiO₃-type material, but also Pb(Zr, Ti)O₃-type material, (Pb, La)(Zr, Ti)O₃-type material, and the like are known. Any material containing one of these materials as a major component and having a piezoelectric function may be used. A mixture of the material and other element may be used, or an inevitable impurity may also produce the same effect.

With respect to these ferroelectric materials, in the invention of this application, mobile point defects are arranged. As in a piezoelectric material consisting of BaTiO₃, (Ba, Sr)TiO₃, or a compound obtained by adding other element (ion) to these compounds, in the invention of this application, a lead-free piezoelectric material and a lead-free piezoelectric element can also be provided without using Pb (lead) which is not preferable for human health or environment.

When elements (ions) to be added are used, as these elements, at least one of an alkali metal, an alkali-earth metal, and a transition metal may be used. For example, at least one of Na, K, Mg, Ca, Al, V, Cr, Mn, Fe, Co, Ni, Zn, Ga, Rb, Y, Zr, Nb, Mo, Ru, Rh, Ag, Sn, Hf, Ta, W, Os, Ir, Pt, Pb, Bi, and a rare-earth element may be used.

More specifically, BaTiO₃ : BT, (Ba, Sr)TiO₃ : BST, ferroelectric materials added with at least one of alkali metals such as K, Na, and Rb, Fe, and Mn in these materials, Pb(Zr, Ti)O₃ : PZT, (Pb, La)(Zr, Ti)O₃ : PLZT, and materials added with other element in these materials may be exemplified.

When the element is added, it is preferably considered that a molar ratio may be generally set at 20 mol% or less. In particular, as a piezoelectric material added with the element, Mn-added BT : BaTiO₃ (containing Mn at 10 mol% or less) or Mn-added BST : (Ba, Sr)TiO₃ (containing Mn at 10 mol% or less, and Sr/Ba atomic ratio is 0.5 or less) may be exemplified.

According to the piezoelectric materials of the invention of this application, a giant piezoelectric deformation: electrostrain can be generated at lower voltage.

For this reason, the piezoelectric material of the invention of this application is very useful and advantageous to applications to various sensors such as acceleration sensor, knocking sensor, and AE sensor, various electric devices and machines such as ultrasonic microphone, piezoelectric loudspeaker, piezoelectric actuator, ultrasonic motor, printer head, gun for an ink-jet printer, or parts of the sensors, the devices, and the machines.

Therefore, examples will be described in more details. The invention is, of course, not limited to the following examples.

### <Example 1>

BaTiO₃ single crystal was fabricated by a flux method, cooled, and then subjected to an aging treatment below Curie temperature (at 80°C for three days). An electric field - deformation characteristic of the obtained piezoelectric material is shown as curve d in FIG. 3. In FIG. 3, as described above, deformation characteristics of the conventional piezoelectric materials are shown as curves a, b, and c, respectively.

As is apparent from the curve d in FIG. 3, the piezoelectric material of the invention of this application can realize reversible domain switching at low electric field, and the piezoelectric material exhibits a giant non-linear piezoelectric effect,

By rearrangement of a small number of oxygen vacancies (point defects) naturally included in BaTiO₃ single crystal by the aging treatment (symmetry of short-range order of point defects is made to coincide with crystal symmetry), a giant piezoelectric deformation of about 0.5% can be obtained at low electric field (200 V/mm).

The deformation has a magnitude that is approximately tens of times as large as that of each of the conventional resultant piezoelectric deformations (curves a to c in FIG. 3) at the same electric field of a popularly used PZT piezoelectric element. Furthermore, it is understood that the deformation is steep and has a non-linear characteristic.

### <Example 2>

(BaK)TiO₃ single crystal added with a small amount of K (0.7 mol%) was fabricated by a flux method.

The resultant (BaK)TiO₃ single crystal was cooled and then subjected to an aging treatment below Curie temperature (at room temperature of 18°C to 22°C for one month).

In this case, point defects were generated by addition of K ions, the aging treatment was performed below Curie temperature to cause the symmetry of short-range order of the point defects to coincide with the crystal symmetry. An electrostrain characteristic of the obtained piezoelectric material is indicated by curve e in FIG. 3.

According to the curve e in FIG. 3, a large piezoelectric deformation of 0.52 % is obtained at an electric field of 1470 V/mm. This deformation is very large in comparison with the results (curves a to c in FIG. 3) at the same electric field in a popularly used conventional PZT piezoelectric element. Furthermore, it is understood that the deformation is steep and that the piezoelectric material has a non-linear characteristic.

In addition, since the piezoelectric material does not use toxic lead, the piezoelectric material is environment-friendly.

### <Example 3>

The next three ceramics (polycrystal) samples were prepared as piezoelectric materials of the invention of this application.
1) (Pb, La)(Zr, Ti)O₃ = PLZT ceramics was subjected to an aging treatment at room temperature (without polarization) for 30 days.
2) Mn-(Ba, Sr)TiO₃ : Mn-BST (containing Mn at 1 mol%) ceramics was subjected to an aging treatment at 70°C for 5 days.
3) Mn-BaTiO₃ : Mn-BT (containing Mn at 1 mol%) ceramics was subjected to an aging treatment at room temperature for 3 months.

With respect to the above three ceramics piezoelectric materials, electric field - deformation characteristics were measured. The results are shown in FIG. 4.

For comparison, measurement results of conventional hard PZT and soft PZT are also shown in FIG. 4.

As is apparent from FIG. 4, PLZT ceramic piezoelectric material of the invention of this application exhibits a deformation magnitude which is several times as large as that of a conventional material at low voltage. Also, in Mn-BST and Mn-BT, reversible deformation occurs. Since the materials do not contain toxic lead, the materials are promising in view of environment.

### <Example 4>

With respect to Mn-BT ceramics in Example 3, electric field - polarization characteristics were measured with a voltage cycle of 0 V, 800 V, -800 V, and 0 V. The results are shown in FIG. 5.

Microscopy images obtained by observing crystal states A to J in FIG. 5 are shown in FIG. 6.

From FIGS. 5 and 6, generation of reversible switching of ferroelectric domains in the piezoelectric material of the invention of this application is confirmed.

### <Example 5>

BaTiO₃ : Fe-BT single crystal containing 0.02 at% of Fe was manufactured and subjected to an aging treatment at a temperature of 80°C for 5 days. The resultant material was measured in electric field - piezoelectric deformation characteristic. As a result, a giant reversible deformation of 0.75 % was obtained at low electric field of 200 V/mm. This value is 40 times as large as an electrostrain obtained by the conventional PZT. The value is also 10 or more times as large as electrostrain obtained by a recent PZN-PT single crystal.

### Industrial Applicability

As has been described above in detail, according to the invention of this application, a giant deformation can be realized at low electric field. Furthermore, a new piezoelectric material having a non-linear characteristic in which the deformation steeply increases at a critical electric field, a piezoelectric element and an electric device or machine using the piezoelectric material, and parts for the element and the device or machine are provided.

## Claims

1. A piezoelectric material which is a ferroelectric and piezoelectric having mobile point defects, wherein the mobile point defects are arranged such that the symmetry of short-range order of the point defects coincides with the crystal symmetry of the ferroelectric phase, and the piezoelectric material exhibits a non-linear piezoelectric effect by reversible switching of domains under electric field.

2. The piezoelectric material according to claim 1, wherein the mobile point defects are vacancies of an element constituting the ferroelectric material introduced by either chemical equilibrium or doping.

3. The piezoelectric material according to claim 1 or 2, wherein the piezoelectric material is subject to an aging treatment at a temperature below Curie temperature, and the point defects are arranged such that the symmetry of the short-range order of the point defects coincides with the crystal symmetry of the ferroelectric phase.

4. The piezoelectric material according to any one of claims 1 to 3, wherein the piezoelectric material is a single crystal or a polycrystal.

5. The piezoelectric material according to any one of claims 1 to 3, wherein the piezoelectric material is a thin film.

6. The piezoelectric material according to claim 5, wherein the piezoelectric material is a multilayer film.

7. The piezoelectric material according to any one of claims 1 to 6, wherein the ferroelectric material is ABO₃-type ferroelectric material.

8. The piezoelectric material according to claim 7, wherein the ferroelectric material is BaTiO₃, (Ba, Sr)TiO₃-type ferroelectric material.

9. The piezoelectric material according to claim 7, wherein the ferroelectric material is Pb(Zr, Ti)O₃ or (Pb, rare-earth element)(Zr, Ti)O₃-type ferroelectric material.

10. The piezoelectric material according to any one of claims 7 to 9, wherein other element is added.

11. The piezoelectric material according to claim 10, wherein the other element is at least one element of an alkali metal, an alkali-earth metal, and a transition metal.

12. The piezoelectric material according to claim 8 or 9, wherein the other element is added by 20 mol % or less.

13. The piezoelectric material according to any one of claims 10 to 12, wherein the other element is at least one of Na, K, Mg, Ca, Al, V, Cr, Mn, Fe, Co, Ni, Zn, Ga, Rb, Sr, Y, Zr, Nb, Mo, Ru, Rh, Ag, Sn, Hf, Ta, W, Os, Ir, Pt, Pb, Bi, and a rare-earth element.

14. A piezoelectric material exhibiting a non-linear piezoelectric effect, wherein the piezoelectric material is at least one of ABO₃-type ferroelectric material and a ferroelectric material obtained by adding other element to ABO₃-type ferroelectric material, and wherein the piezoelectric material has been subjected to an aging treatment at a temperature below Curie temperature.

15. The piezoelectric material exhibiting the non-linear piezoelectric effect according to claim 14, wherein the piezoelectric material is at least one of BaTiO₃, (Ba, Sr)TiO₃, and a ferroelectric material obtained by adding at least one of K, Fe, and Mn to BaTiO₃ or (Ba, Sr)TiO₃.

16. The piezoelectric material exhibiting the non-linear piezoelectric effect according to claim 14, wherein the piezoelectric material is (Pb, La)(Zr, Ti)O₃ ferroelectric material.

17. A method of manufacturing a piezoelectric material according to any one of claims 1 to 13, comprising steps of:
(a) introducing mobile point defects in a ferroelectric material; and
(b) arranging the point defects such that the symmetry of short-range order of the mobile point defects coincides with the crystal symmetry of the ferroelectric phase,
and wherein the ferroelectric material exhibits a non-linear piezoelectric effect by reversible switching of domains thereof under electric field.

18. A method of manufacturing a piezoelectric material exhibiting a non-linear piezoelectric effect, wherein at least one of ABO₃-type ferroelectric material and a ferroelectric material obtained by adding other element to ABO₃-type ferroelectric material is subjected to an aging treatment at a temperature below Curie temperature.

19. The method of manufacturing a piezoelectric material according to claim 18, wherein the piezoelectric material is at least one of BaTiO₃, (Ba, Sr)TiO₃, and a ferroelectric material obtained by adding at least one of K, Fe, and Mn to BaTiO₃ or (Ba, Sr)TiO₃.

20. The method of manufacturing a piezoelectric material according to claim 18, wherein the piezoelectric material is (Pb, La)(Zr, Ti)O₃ ferroelectric material.

21. A non-linear piezoelectric element wherein the piezoelectric material according to any one of claims 1 to 16 partially constitutes the non-linear piezoelectric element.

22. An electric device or machine or parts thereof, wherein the non-linear piezoelectric element according to claim 21 is incorporated as at least a part of a configuration.

23. An electric device or machine or parts thereof, wherein the piezoelectric material according to any one of claims 1 to 16 is used as at least a part of the configuration of the electric device or machine or parts thereof.
